(19) Europäisches Patentamt
European Patent Office
Office européen des brevets

(11) **EP 4 761 534 A1**

(12) **EUROPEAN PATENT APPLICATION**
published in accordance with Art. 153(4) EPC

(43) Date of publication:
**17.06.2026  Bulletin 2026/25**

(21) Application number: **24904213.6**

(22) Date of filing: **09.12.2024**

(51) International Patent Classification (IPC):
**H10H 29/851** (2025.01)    **H10H 29/14** (2025.01)
**H10H 29/24** (2026.01)    **H10H 29/85** (2025.01)
**G02B 5/20** (2006.01)

(52) Cooperative Patent Classification (CPC):
**F21S 2/00; F21V 9/08; F21V 9/20; F21V 9/32;
G02B 5/18; G02B 5/20; G02B 5/26; G02F 1/1335;
G09F 9/30; G09F 9/33; H10H 29/14; H10H 29/24;
H10H 29/85; H10H 29/851**

(86) International application number:
**PCT/KR2024/020091**

(87) International publication number:
**WO 2025/127648 (19.06.2025 Gazette 2025/25)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **14.12.2023  JP 2023210874**

(71) Applicant: **Samsung Electronics Co., Ltd.**
**Suwon-si, Gyeonggi-do 16677 (KR)**

(72) Inventors:
• **MURATA, Koji**
  **Yokohama-shi, Kanagawa 230-0027 (JP)**
• **KIM, Dohoon**
  **Yokohama-shi, Kanagawa 230-0027 (JP)**
• **HASEGAWA, Eiji**
  **Yokohama-shi, Kanagawa 230-0027 (JP)**

(74) Representative: **Gulde & Partner**
**Patent- und Rechtsanwaltskanzlei mbB**
**Berliner Freiheit 2**
**10785 Berlin (DE)**

(54) **DISPLAY DEVICE**

(57)    A display device capable of more efficiently extracting, to the outside, light having transmitted a wavelength conversion layer is provided. The provided display device comprises: a light source which is provided in each of a first pixel and a second pixel, and which emits light of a first wavelength; a first wavelength conversion layer which is formed in the first pixel and which converts the light of the first wavelength into light of a second wavelength; a second wavelength conversion layer which is formed in the second pixel and converts the light of the first wavelength into light of a third wavelength that differs from the second wavelength; a first color filter, which is provided in the first pixel and selectively transmits the light of the second wavelength; a second color filter, which is provided in the second pixel and selectively transmits the light of the third wavelength; and at least a plurality of nanomembers on which the light of the second wavelength and the light of the third wavelength are incident, wherein: the plurality of nanomembers include a high refractive index dielectric material; and the plurality of nanomembers are arranged in the first pixel at a first period, and the plurality of nanomembers are arranged in the second pixel at a second period that differs from the first period.

FIG. 1

**Description**

[Technical Field]

The disclosure relates to a display device.

[Background Art]

Recently, development of display devices with a wavelength conversion layer is in progress. In these display devices, the light emitted from a light source is wavelength-converted through the wavelength conversion layer and taken out.

Further, methods for increasing light utilization efficiency using multiple nano members have been proposed.

The above information is presented as related art only to assist with an understanding of the disclosure. No determination has been made, and no assertion is made, as to whether any of the above might be applicable as prior art with regard to the disclosure.

[Detailed Description of the Invention]

[Technical Problem]

In a display device having a wavelength conversion layer, it is preferable to more efficiently take out light transmitted through the wavelength conversion layer.

Aspects of the disclosure are to address at least the above-mentioned problems and/or disadvantages and to provide at least the advantages described below. Accordingly, an aspect of the disclosure is to provide a display device capable of more efficiently taking out light transmitted through a wavelength conversion layer.

Additional aspects will be set forth in part in the description which follows and, in part, will be apparent from the description, or may be learned by practice of the presented embodiments.

[Technical Solution]

In accordance with another aspect of the disclosure, a display device including, at least, a light source provided in each of a first pixel and a second pixel and configured to emit light of a first wavelength, a first wavelength conversion layer formed in the first pixel and configured to convert the light of the first wavelength into light of a second wavelength, a second wavelength conversion layer formed in the second pixel and configured to convert the light of the first wavelength into light of a third wavelength different from the second wavelength, a first color filter provided in the first pixel and configured to selectively transmit the light of the second wavelength, a second color filter provided in the second pixel and configured to selectively transmit the light of the third wavelength, and a plurality of nano members on which the light of the second wavelength and the light of the third wavelength are incident, and wherein the plurality of nano members include a high refractive index dielectric, and wherein the plurality of nano members are arranged in the first pixel in a first periodic distance, and wherein the plurality of nano members are arranged in the second pixel in a second periodic distance different from the first periodic distance.

In a display device according to an embodiment of the disclosure, the display device further includes an overcoat layer formed between the first color filter and the first wavelength conversion layer and between the second color filter and the second wavelength conversion layer, wherein he plurality of nano members are provided between the overcoat layer and each of the first wavelength conversion layer and the second wavelength conversion layer.

In a display device according to an embodiment of the disclosure, the light source is further provided in a third pixel, and wherein the plurality of nano members are further disposed in the third pixel in a third periodic distance different from the first periodic distance and the second periodic distance.

In a display device according to an embodiment of the disclosure, the light of the second wavelength is light of a red wavelength band, and the light of the third wavelength is light of a green wavelength band.

In a display device according to an embodiment of the disclosure, the first periodic distance is longer than the second periodic distance, and the second periodic distance is longer than the third periodic distance.

In a display device according to an embodiment of the disclosure, the first periodic distance is 500 nm or more and 700 nm or less, the second periodic distance is 450 nm or more and 500 nm or less, and the third periodic distance is 350 nm or more and 430 nm or less.

In a display device according to an embodiment of the disclosure, the plurality of nano members arranged in the first periodic distance resonate with the light of the second wavelength, and the plurality of nano members disposed in the second periodic distance resonate with the light of the third wavelength.

In a display device according to an embodiment of the disclosure, the plurality of nano members have a refractive index of 2.0 or more.

In accordance with another aspect of the disclosure, the high refractive index dielectric material includes at least one of titanium oxide (TiO2) and silicon (Si).

In a display device according to an embodiment of the disclosure, the plurality of nano members have a column, conical, hemispherical, or cap shape.

In a display device according to an embodiment of the disclosure, the first wavelength conversion layer and the second wavelength conversion layer each include a plurality of nanoparticles.

In a display device according to an embodiment of the disclosure, the plurality of nanoparticles each include at least one of silver (Ag) and aluminum (Al).

(In a display device according to an embodiment of the disclosure, the light source is a display device including a micro light emitting diode (LED).

In a display device according to an embodiment of the disclosure, the light of the first wavelength is light of a blue wavelength band.

In a display device according to an embodiment of the disclosure, the first wavelength conversion layer and the second wavelength conversion layer each include at least one of a quantum dot and a phosphor.

In a display device according to an embodiment of the disclosure, the display device further includes an overcoat layer formed between the first color filter and the first wavelength conversion layer and between the second color filter and the second wavelength conversion layer, and a transparent substrate facing the overcoat layer with the first color filter and the second color filter interposed therebetween, wherein the plurality of nano members are provided between the transparent substrate, the first color filter, and the second color filter.

In a display device according to an embodiment of the disclosure, the overcoat layer has a refractive index of 1.3 or less.

In a display device according to an embodiment of the disclosure, the display device further comprising a first dichroic filter provided between the first wavelength conversion layer and the first color filter and configured to transmit the light of the second wavelength and reflect the light of the first wavelength and a second dichroic filter provided between the second wavelength conversion layer and the second color filter and configured to transmit the light of the third wavelength and reflect the light of the first wavelength.

[Advantageous Effects]

In a display device according to an embodiment of the disclosure, a plurality of nano members is disposed in a first periodic distance in a first pixel, and a plurality of nano members is disposed in a second periodic distance in a second pixel.

According to an embodiment, a plurality of nano members is disposed in a periodic distance matching each of a second wavelength of light and a third wavelength of light. Accordingly, each of the second wavelength of light and the third wavelength of light are efficiently taken out from the display device. Therefore, it is possible to efficiently taken out the light passing through the wavelength conversion layer.

Other aspects, advantages, and salient features of the disclosure will become apparent to those skilled in the art from the following detailed description, which, taken in conjunction with the annexed drawings, discloses various embodiments of the disclosure.

[Brief Description of the Drawings]

The above and other aspects, features, and advantages of certain embodiments of the disclosure will be more apparent from the following description taken in conjunction with the accompanying drawings, in which:

FIG. 1 is a cross-sectional view illustrating a display device configuration according to an embodiment of the disclosure;

FIG. 2A is a view illustrating a planar configuration of the red conversion layer and the nano member illustrated in FIG. 1 according to an embodiment of the disclosure;

FIG. 2B is a view illustrating a cross-sectional configuration taken along line B-B of FIG. 2A according to an embodiment of the disclosure;

FIG. 3A is a cross-sectional view illustrating another example of the nano member configuration illustrated in FIG. 2B according to an embodiment of the disclosure;

FIG. 3B is a cross-sectional view illustrating another example of the nano member configuration illustrated in FIG. 2B according to an embodiment of the disclosure;

FIG. 3C is a cross-sectional view illustrating another example of the nano member configuration illustrated in FIG. 2B according to an embodiment of the disclosure;

FIG. 3D is a cross-sectional view illustrating another example of the nano member configuration illustrated in FIG. 2B according to an embodiment of the disclosure;

FIG. 4A is a cross-sectional view illustrating a red conversion layer configuration illustrated in FIG. 1 according to an embodiment of the disclosure;

FIG. 4B is a cross-sectional view illustrating a green conversion layer configuration illustrated in FIG. 1 according to an embodiment of the disclosure;

FIG. 5A is a cross-sectional view illustrating process 1 of a method for manufacturing the display device illustrated in FIG. 1 according to an embodiment of the disclosure;

FIG. 5B is a cross-sectional view illustrating a process subsequent to FIG. 5A according to an embodiment of the disclosure;

FIG. 6A is a view illustrating light taken out from a display device according to a comparative embodiment;

FIG. 6B is a view illustrating light taken out from the display device illustrated in FIG. 1 according to an embodiment of the disclosure;

FIG. 7 is a cross-sectional view illustrating a red pixel configuration of a display device according to an embodiment of the disclosure; and

FIG. 8 is a cross-sectional view illustrating a red pixel configuration of a display device according to modified example 1 according to an embodiment of the disclosure.

Throughout the drawings, it should be noted that like reference numbers are used to depict the same or similar elements, features, and structures.

[Mode for Carrying out the Invention]

The following description with reference to the accompanying drawings is provided to assist in a comprehensive understanding of various embodiments of the disclosure as defined by the claims and their equivalents. It includes various specific details to assist in that understanding but these are to be regarded as merely exemplary.

Accordingly, those of ordinary skill in the art will recognize that various changes and modifications of the various embodiments described herein can be made without departing from the scope and spirit of the disclosure. In addition, descriptions of well-known functions and constructions may be omitted for clarity and conciseness.

The terms and words used in the following description and claims are not limited to the bibliographical meanings, but, are merely used by the inventor to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

As used herein, when an element is referred to as being "on" or "over" another element, the element may be on or over the other element while touching, or without touching, the other element. As used herein, when an element is referred to as being "under" or "below" another element, the element may be under or below while touching, or without touching, the other element.

As used herein, when a part "comprises," "includes," or "has" an element, it may further comprise, include, or have another element without excluding the other element unless stated otherwise.

Steps constituting a method may be performed in appropriate order unless an order is specifically mentioned or described otherwise. The steps are not necessarily limited as being performed in the mentioned order. Use of all examples or terms is intended merely for describing the technical scope and, unless limited by the claims, the scope is not limited by the examples or terms.

It should be appreciated that the blocks in each flowchart and combinations of the flowcharts may be performed by one or more computer programs which include instructions. The entirety of the one or more computer programs may be stored in a single memory device or the one or more computer programs may be divided with different portions stored in different multiple memory devices.

Any of the functions or operations described herein can be processed by one processor or a combination of processors. The one processor or the combination of processors is circuitry performing processing and includes circuitry like an application processor (AP, e.g. a central processing unit (CPU)), a communication processor (CP, e.g., a modem), a graphics processing unit (GPU), a neural processing unit (NPU) (e.g., an artificial intelligence (AI) chip), a Wi-Fi chip, a Bluetooth® chip, a global positioning system (GPS) chip, a near field communication (NFC) chip, connectivity chips, a sensor controller, a touch controller, a finger-print sensor controller, a display driver integrated circuit (IC), an audio CODEC chip, a universal serial bus (USB) controller, a camera controller, an image processing IC, a microprocessor unit (MPU), a system on chip (SoC), an IC, or the like.

Further, in the following description, the ordinal numbers, such as "first" and "second," are used for convenience, and do not define any specific order, unless otherwise specified.

[First embodiment]

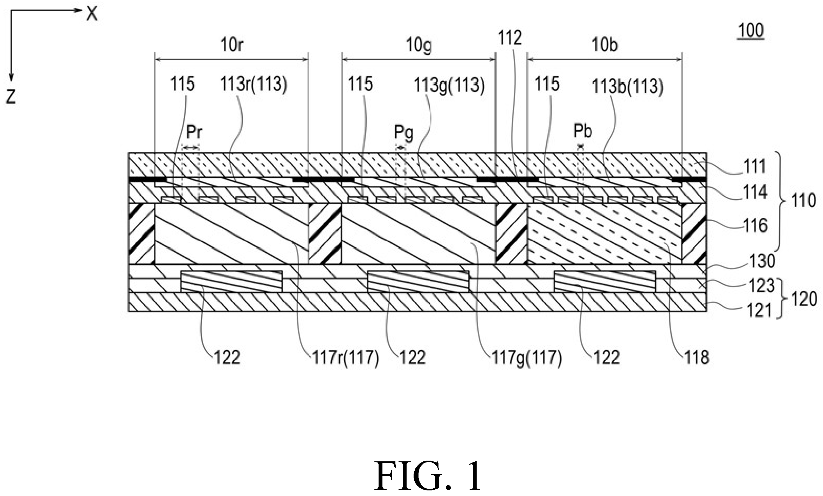

FIG. 1 illustrates a cross-sectional view of a display device according to an embodiment of the disclosure.

Referring to FIG. 1, a display device 100 may include a first structure 110, a second structure 120, and a bonding portion 130. In the display device 100, e.g., the second structure 120 and the first structure 110 may be stacked, and the bonding portion 130 may be formed therebetween. The second structure 120 may include a light source 122. The light emitted from the light source 122 may sequentially pass through the bonding portion 130 and the first structure 110 and may be taken out from the display device 100. The light source 122 may emit, e.g., light in a blue wavelength band (e.g., 430 nm to 495 nm). The light source 122 may emit light of another wavelength band such as ultraviolet rays.

A plurality of red pixels 10r, a plurality of green pixels 10g, and a plurality of blue pixels 10b may be arranged in a matrix shape in the display device 100. Light of a red wavelength band (e.g., 600 nm to 750 nm) may be taken out from the red pixel 10r, light of a green wavelength band (e.g., 495 nm to 570 nm) may be taken out from the green pixel 10g, and light of a blue wavelength band may be taken out from the blue pixel 10b. In the following description, the stacking direction of the second structure 120 and the first structure 110 may be referred to as a Z direction, and the arrangement directions of the red pixel 10r, the green pixel 10g, and the blue pixel 10b may be referred to as an X direction and a Y direction.

<Configuration of display device 100>

(First Structure 110)

The first structure 110 may include, e.g., a transparent substrate 111, a light blocking matrix 112, a color filter 113, an overcoat layer 114, a nano member 115 which is a high refractive index dielectric material, a partition wall 116, a color conversion layer 117, and a transparent layer 118. The color filter 113 may include, e.g., a red color filter 113r, a green color filter 113g, and a blue color filter 113b. The color conversion layer 117 may include, e.g., a red conversion layer 117r and a green conversion layer 117g.

In the red pixel 10r, the transparent substrate 111, the red color filter 113r, the overcoat layer 114, the nano member 115, and the red conversion layer 117r may be sequentially arranged along the Z direction. In the green pixel 10g, the transparent substrate 111, the green color filter 113g, the overcoat layer 114, the nano member 115, and the green conversion layer 117g may be sequentially arranged along the Z direction. In the blue pixel 10b, the transparent substrate 111, the blue color filter 113b, the overcoat layer 114, the nano member 115, and the transparent layer 118 may be arranged in this order along the Z direction.

The transparent substrate 111 may be, e.g., a plate shape portion having a rectangular plane (XY plane). The transparent substrate 111 may have light transmittance. The transparent substrate 111 may include, e.g., a glass material, a resin material, or the like. The resin material may be, e.g., polyimide or the like. The transparent substrate 111 may have flexibility.

The light blocking matrix 112 may be a so-called black matrix. The light blocking matrix 112 may be provided between one main surface of the transparent substrate 111 and the overcoat layer 114, together with, e.g., the color filter 113. The light blocking matrix 112 may serve to prevent color mixing of light emitted from the red pixel 10r, the green pixel 10g, and the blue pixel 10b. The light blocking matrix 112 may be provided, e.g., between the red color filter 113r and the green color filter 113g, between the green color filter 113g and the blue color filter 113b, and between the blue color filter 113b and the red color filter 113r. An end portion of the light blocking matrix 112 may overlap an end portion of the color filter 113. The light blocking matrix 112 may be formed of a patternable light blocking material.

The color filter 113 may selectively transmit light of a predetermined wavelength band. According to an embodiment, the red color filter 113r may selectively transmit light of a red wavelength band. The green color filter 113g may selectively transmit light of a green wavelength band. The blue color filter 113b may selectively transmit light of a blue wavelength band. By providing the color filter 113, the color purity of light taken out from each of the red pixel 10r, the green pixel 10g, and the blue pixel 10b may be increased. The color filter 113 may include, e.g., a resin material.

The overcoat layer 114 may be formed between the color filter 113 and the nano member 115 and between the light blocking matrix 112 and the partition wall 116. The overcoat layer 114 may serve to protect the color filter 113 while planarizing the main surface side of the transparent substrate 111 provided with the light blocking matrix 112 and the color filter 113. The overcoat layer 114 may include, e.g., a photosensitive acrylic resin. The refractive index of the overcoat layer 114 may be, e.g., about 1.5.

A plurality of nano members 115 may be provided in each of the red pixel 10r, the green pixel 10g, and the blue pixel 10b. In the red pixel 10r, a plurality of nano members 115 may be provided between the red color filter 113r and the red

5

conversion layer 117r. In the green pixel 10g, a plurality of nano members 115 may be provided between the green color filter 113g and the green conversion layer 117g. In the blue pixel 10b, a plurality of nano members 115 may be provided between the blue color filter 113b and the transparent layer 118.

The nano member 115 may include a high refractive index dielectric material. The high refractive index dielectric may be, e.g., a material having a refractive index of 2.0 or more. The high refractive index dielectric may be, e.g., titanium oxide ($TiO_2$), zinc oxide (ZnO), zirconium oxide ($ZrO_2$), or silicon (Si). For example, the refractive index at a wavelength of 600 nm is 2.5 for titanium oxide, 2.0 for zinc oxide, 2.1 for zirconium oxide, and 4.2 for silicon. The nano member 115 may include at least one of titanium oxide and silicon. The nano member 115 may include, e.g., a resin material and nanoparticles of a high refractive index dielectric dispersed in the resin material. The nano member 115 may be formed of a high refractive index dielectric material.

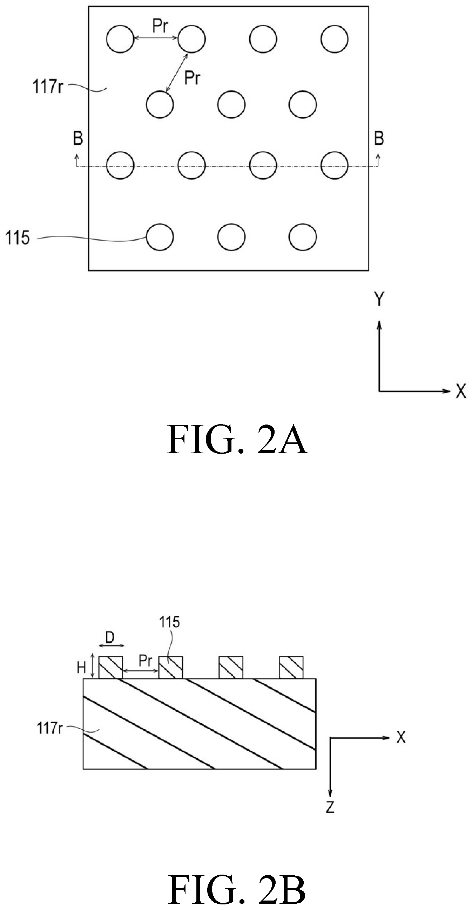

FIGS. 2A and 2B illustrate a configuration of a plurality of nano members provided in a red pixel together with a red conversion layer according to various embodiments of the disclosure.

FIG. 2A illustrates an arrangement of a plurality of nano members 115 in an XY plane, and FIG. 2B illustrates a cross-sectional view taken along line B-B of FIG. 2A.

Referring to FIGS. 2A and 2B, the nano member 115 may be, e.g., cylindrical. The height direction of the cylinder may be disposed parallel to the Z direction. The diameter D of the nano member 115 may be, e.g., 300 nm to 450 nm in the red pixel 10r, 250 nm to 350 nm in the green pixel 10g, and 200 nm to 300 nm in the blue pixel 10b. The height H of the nano member 115 may be 150 nm to 300 nm. The plurality of nano members 115 may be regularly disposed in each of, e.g., the red pixel 10r, the green pixel 10g, and the blue pixel 10b. In the red pixel 10r, the green pixel 10g, and the blue pixel 10b, e.g., the plurality of nano members 115 may be disposed in a triangular grid shape.

When light having a visible wavelength is incident on the plurality of nano members 115, a Mie resonance may occur, causing a light localization phenomenon near each nano member 115. The localized light may be emitted by generating a diffraction by a periodic arrangement of the nano members 115. Accordingly, the traveling direction of light may be changed by the plurality of nano members 115. Specifically, the relationship between incident light and diffracted light in the plurality of nano members 115 may be expressed by Equation 1 below.

[Eqation 1]

$$\vec{k}_{out} = \vec{k}_{in}(\theta_{in}) \pm \vec{G} \quad \ldots \ldots (1)$$

In Equation 1,

$\vec{k}_{out}$ is the wavenumber vector of diffracted light,
$\vec{k}_{in}(\theta_{in})$ is the wave vector of incident light, and
$\vec{G}$ is the lattice vector.
$\vec{k}_{in}(\theta_{in})$ may depend on the shape of the nano member 115, the wavelength of light incident on the nano member 115, the incident angle of the nano member 115, and the like, and $\vec{G}$ may depend on the periodic distance in which the plurality of nano members 115 are arranged.

According to and embodiment, periodic distance may mean the distance between nano members 115 that repeat periodically. For example, periodic distance is the distance between adjacent red pixels 10r among plurality of red pixels 10r, the distance between adjacent green pixels 10g among plurality of green pixels 10g and the distance between adjacent blue pixels 10b among plurality of blue pixels 10b.

According to an embodiment, arrangement periodic distances of the plurality of nano members 115 may be different between the red pixel 10r, the green pixel 10g, and the blue pixel 10b. According to an embodiment, the periodic distance of the plurality of nano members 115 may be adjusted according to the wavelength of light taken out from each of the red pixel 10r, the green pixel 10g, and the blue pixel 10b. For example, the plurality of nano members 115 are disposed in a periodic distance Pr in the red pixel 10r, a periodic distance Pg in the green pixel 10g, and a periodic distance Pb in the blue pixel 10b, respectively.

Lattice-coupled resonance may be generated in the light of the red wavelength band by the plurality of nano members 115 disposed in the periodic distance Pr. Lattice-coupled resonance may be generated in the light of the green wavelength band by the plurality of nano members 115 disposed in the periodic distance Pg. Lattice-coupled resonance may be generated in the light of the blue wavelength band by the plurality of nano members 115 disposed in the periodic distance Pb. Due to the lattice-coupled resonance, a light localization phenomenon may occur in the vicinity of each of the plurality of nano members 115, and directivity of light taken out from each of the red pixel 10r, the green pixel 10g, and the blue pixel 10b may be increased. As is described below, the light of each of the red wavelength band, the green wavelength band, and the blue wavelength band may be efficiently taken out from the display device 100 to the outside.

For example, the longer the wavelength of light emitted from the pixel, the longer the periodic distance of the plurality of nano members 115 is. For example, the periodic distance Pr is longer than the periodic distance Pg, and the periodic distance Pg is longer than the periodic distance Pb. In other words, the periodic distances Pr, Pg, and Pb may meet Equation 2 below.

[Eqauation 2]

Periodic distance Pr> Periodic distance Pg> Periodic distance Pb

The periodic distance Pr may be, e.g., 500 nm or more and 700 nm or less, the periodic distance Pg may be, e.g., 450 nm or more and 500 nm or less, and the periodic distance Pb may be, e.g., 350 nm or more and 430 nm or less.

The periodic distances Pr, Pg, and Pb of the nano member 115 and the resonance wavelength (scattering wavelength) by the nano member 115 may have, e.g., the following relationship. In this case, the cylindrical nano member 115 may have a diameter D of 400 nm and a height H of 300 nm, and the nano members 115 may be arranged in a triangular lattice shape. The nano member 115 may include silicon. For example, when the periodic distance Pr is 550 nm, 580 nm, and 600 nm, the resonance wavelength of the nano member 115 is 600 nm, 630 nm, and 650 nm. When the periodic distance Pg is 450 nm, 480 nm, and 500 nm, the resonance wavelength of the nano member 115 may be 500 nm, 530 nm, and 550 nm. When the periodic distance Pb is 350 nm, 400 nm, and 430 nm, the resonance wavelength of the nano member 115 may be 400 nm, 430 nm, and 480 nm.

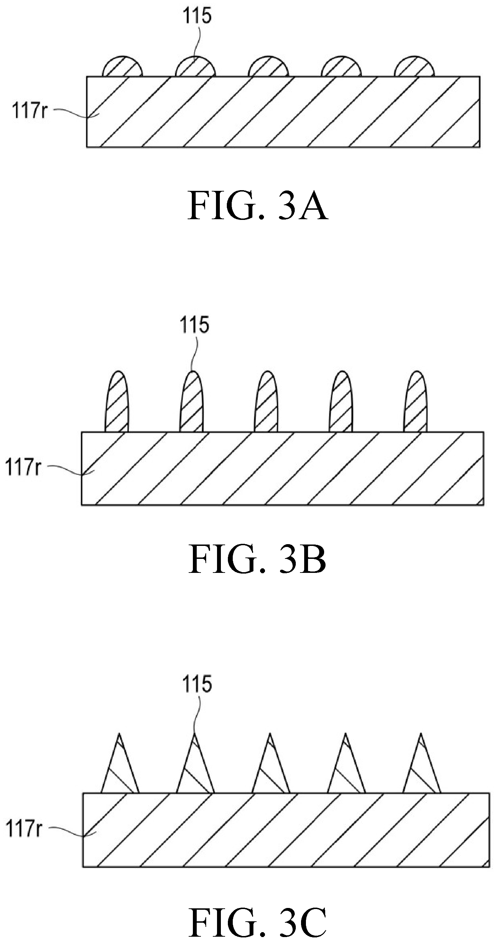

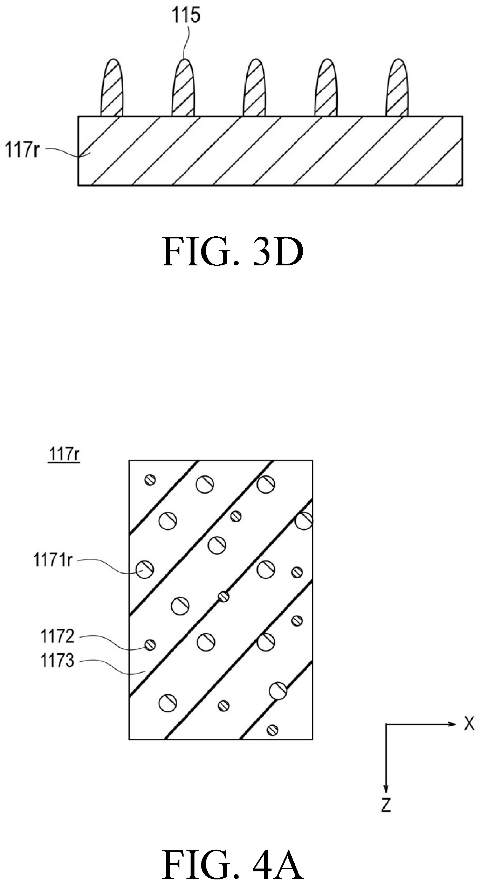

FIGS. 3A, 3B, 3C, and 3D illustrate another example of the nano member illustrated in FIG. 2B according to various embodiments of the disclosure. Referring to FIGS. 3A, 3B, 3C and 3D, the nano member 115 may have a hemispherical shape (FIGS. 3A and 3D). In this case, the plane of the hemisphere may be disposed toward the red conversion layer 117r (FIG. 3A), or the spherical surface of the hemisphere may be disposed toward the red conversion layer 117r (FIG. 3B). The nano member 115 may have a cap shape (FIG. 3B). Alternatively, the nano member 115 may have a conical shape such as a cone, a triangular cone, and a square cone. The nano member 115 may have a columnar shape other than a cylinder, and may have, e.g., a shape such as a triangular column and a square column (not shown).

The partition wall 116 may partition the red pixel 10r, the green pixel 10g, and the blue pixel 10b. The height of the partition wall 116 (the size in the Z direction) may be substantially equal to the thicknesses of the red conversion layer 117r, the green conversion layer 117g, and the transparent layer 118. The height of the partition wall 116 may be, e.g., 5 μm or more and 50 μm or less. The partition wall 116 may have light reflection characteristics with respect to light of the wavelength band emitted from the light source 122 and light of the wavelength band converted from the red conversion layer 117r and the green conversion layer 117g. Accordingly, light directly from the partition wall 116, or through the red conversion layer 117r and the green conversion layer 117g from the light source 122, toward the partition wall 116 may be reflected by the partition wall 116. Accordingly, the utilization efficiency of light emitted from the light source 122 may be increased, and the extraction efficiency of light may be enhanced. The partition wall 116 may include, e.g., a white pigment and a resin material. The resin material may be, e.g., a photosensitive resin material such as an acrylic resin, an epoxy resin, a silicone resin, or a polyimide resin.

The color conversion layer 117 formed in the red pixel 10r and the green pixel 10g may convert the wavelength of light incident from the side of the second structure 120 and transmit the same to the side of the plurality of nano members 115.

FIG. 4A illustrates the configuration of the red conversion layer according to an embodiment of the disclosure.

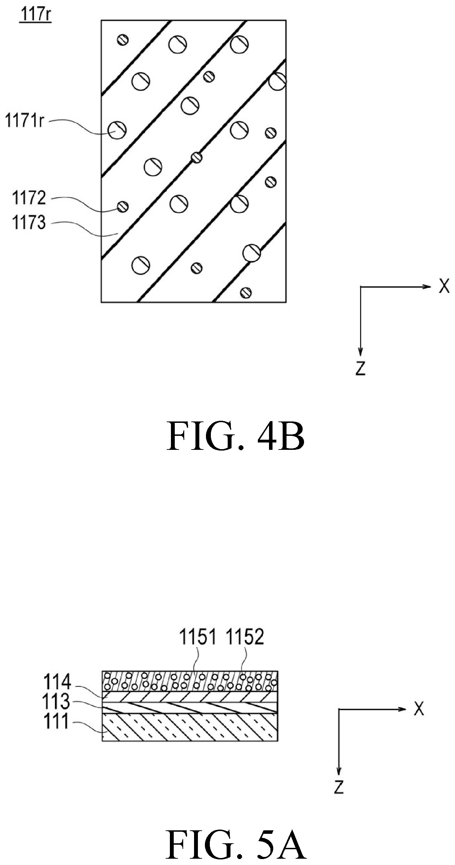

FIG. 4B illustrates the configuration of the green conversion layer according to an embodiment of the disclosure.

Referring to FIGS. 4A and 4B, a red conversion layer 117r formed in the red pixel 10r may include, e.g., a wavelength conversion material 1171r, nanoparticles 1172, and a binder 1173. The green conversion layer 117g formed in the green pixel 10g may include, e.g., a wavelength conversion material 1171g, nanoparticles 1172, and a binder 1173.

The wavelength conversion materials 1171r and 1171g may include, e.g., phosphors or quantum dots. According to an embodiment, the red conversion layer 117r and the green conversion layer 117g may include at least one of a phosphor and quantum dots. The wavelength conversion material 1171r may convert the wavelength of light emitted from the light source 122 into a red wavelength band. The wavelength conversion material 1171g may convert the wavelength of light emitted from the light source 122 into a green wavelength band.

In the red conversion layer 117r and the green conversion layer 117g, a plurality of nanoparticles 1172 may be dispersed in the binder 1173. The nanoparticles 1172 may be configured to enable plasmon absorption of light emitted from the light source 122. The nanoparticles 1172 may include, e.g., a metal material. The nanoparticles 1172 may include, e.g., at least one of silver (Ag) and aluminum (Al). The nanoparticles 1172 may be, e.g., spherical. The particle diameter of the nanoparticles 1172 may be, e.g., 60 nm or more and 100 nm or less. For example, the resonance wavelength of the nanoparticles 1172 overlaps the wavelength of light emitted from the light source 122. For example, the nanoparticles 1172 that includes silver and has a spherical shape may have a resonance wavelength (absorption wavelength) of 410 nm when the particle size is 60 nm, a resonance wavelength of 430 nm when the particle size is 70 nm, a resonance wavelength of 450 nm when the particle size is 80 nm, a resonance wavelength of 470 nm when the particle size is 90 nm, and a resonance wavelength of 490 nm when the particle size is 100 nm.

In the red conversion layer 117r and the green conversion layer 117g including the nanoparticles 1172, wavelength conversion efficiency of light emitted from the light source 122 may be enhanced. According to an embodiment, when the light emitted from the light source 122 is incident on the red conversion layer 117r and the green conversion layer 117g, plasmon absorption of the light occurs in the nanoparticles 1172, thereby generating an augmented electric field. As the augmented electric field acts on the wavelength conversion materials 1171r and 1171g, the wavelength of light emitted from the light source 122 may be converted more efficiently. In other words, light in the red wavelength band and light in the green wavelength band may be more efficiently taken out from the red conversion layer 117r and the green conversion layer 117g.

The binder in which the wavelength conversion materials 1171r and 1171g and the nanoparticles 1172 are dispersed may include, e.g., a resin material such as a silicone resin, an epoxy resin, or an acrylic resin.

The transparent layer 118 formed in the blue pixel 10b may transmit light emitted from the light source 122 to the transparent substrate 111 with a high transmittance. The transparent layer 118 may transmit light emitted from the light source 122 at, e.g., a transmittance of 70% or more. The transparent layer 118 may include, e.g., a resin material.

(Second structure 120)

The second structure 120 may include, e.g., a thin film transistor (TFT) substrate 121, a light source 122, and an anisotropic conductive film 123.

The TFT substrate 121 may be disposed on the transparent substrate 111 which is opposite to the Z direction. The TFT substrate 121 is a substrate for driving the light source 122, and may include, e.g., a substrate, a wiring layer formed on the substrate, and a TFT. The wiring layer may have another driving element instead of the TFT. Alternatively, the display device 100 may be passive matrix driving.

A plurality of light sources 122 may be provided on the TFT substrate 121. The light source 122 may be provided in each of the red pixel 10r, the green pixel 10g, and the blue pixel 10b. The light source 122 may include, e.g., a micro LED. The light source 122 may have, e.g., a rectangular plane (XY plane). The size of one side of this rectangle may be, e.g., 1 μm or more and 100 μm or less. The light source 122 may have a three-dimensional shape such as a rectangular parallelepiped or a cube. The light source 122 may include, e.g., a gallium nitride (GaN)-based semiconductor material, and may emit light in ultraviolet to blue wavelength bands. The anisotropic conductive film 123 may be formed on the TFT substrate 121 together with the plurality of light sources 122.

(Bonding portion 130)

The bonding portion 130 formed between the first structure 110 and the second structure 120 may bond the first structure 110 and the second structure 120. The thickness (the size in the Z direction) of the bonding portion 130 may be, e.g., 5 μm or less. The bonding portion 130 may include an adhesive, or a pressure sensitive adhesive (PSA), or the like. The bonding portion 130 may include, e.g., a transparent epoxy resin, a silicone resin, or the like.

<Method for manufacturing display device 100>

Next, a method for manufacturing a display device 100 is described.

The first structure 110 may be manufactured, e.g., as described below. According to an embodiment, the light blocking matrix 112 and the color filter 113 may be sequentially formed on the transparent substrate 111. In the formation of the color filter 113, the red color filter 113r may be formed in the red pixel 10r, the green color filter 113g may be formed in the green pixel 10g, and the blue color filter 113b may be formed in the blue pixel 10b. Further, the overcoat layer 114 may be formed on the transparent substrate 111 by covering the light blocking matrix 112 and the color filter 113. Further, the plurality of nano members 115 may be formed on the overcoat layer 114.

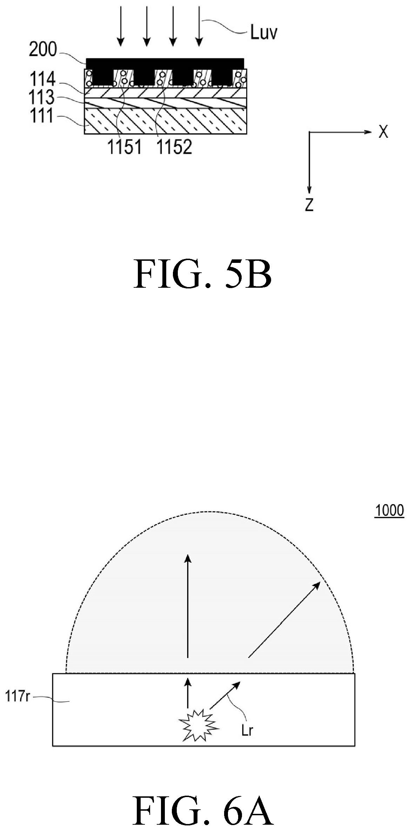

FIGS. 5A and 5B illustrate a method for forming a plurality of nano members 115 according to various embodiments of the disclosure.

Referring to FIGS. 5A and 5B, the plurality of nano members 115 may be formed, e.g., as described below. According to an embodiment, a resin 1151 containing nanoparticles 1152 may be applied on the overcoat layer 114 (FIG. 5A). The resin 1151 may include, e.g., a light-transmissive ultraviolet (UV) resin. The nanoparticles 1152 may be composed of, e.g., nanoparticles of titanium oxide or silicon. According to an embodiment, the plurality of nano members 115 may be formed using a nanoimprint method (FIG. 5B). A nanoimprint mold 200 having a predetermined pattern may be provided on the resin 1151 including the nanoparticles 1152, and be irradiated with ultraviolet light Luv, and the plurality of nano members 115 may be formed with a periodic distance Pr in the red pixel 10r, a periodic distance Pg in the green pixel 10g, and a periodic distance Pb in the blue pixel 10b, respectively.

According to an embodiment, the partition wall 116 may be formed on the overcoat layer 114 using a photolithography process. Further, the color conversion layer 117 and the transparent layer 118 may be formed in the area surrounded by the partition wall 116. Accordingly, the first structure 110 may be formed.

The second structure 120 may be manufactured, e.g., as described below. According to an embodiment, the TFT substrate 121 may be formed. Further, the light source 122 and the anisotropic conductive film 123 may be formed on the TFT substrate 121.

After the first structure 110 and the second structure 120 are formed, the first structure 110 and the second structure 120 may be bonded as is described below. According to an embodiment, a bonding material that becomes the bonding portion 130 may be applied on the second structure 120. Further, the first structure 110 may be positioned to overlap the surface on which the bonding material of the second structure 120 is applied. Further, the first structure 110 and the second structure 120 may be pressed to approach each other under reduced pressure, and energy such as heat or ultraviolet rays may be applied to the bonding material to cure, forming the bonding portion 130. For example, in this way, a full color display device 100 is manufactured.

<Operation effects of display device 100>

In the display device 100, light of, e.g., a blue wavelength band may be emitted from the light source 122 provided in each of the red pixel 10r, the green pixel 10g, and the blue pixel 10b to pass through the bonding portion 130. In the red pixel 10r, light transmitted through the bonding portion 130 may be incident on the red conversion layer 117r and converted into light of a red wavelength band. The light in the red wavelength band may be diffracted by the plurality of nano members 115 disposed in the periodic distance Pr, and may sequentially pass through the overcoat layer 114, the red color filter 113r, and the transparent substrate 111.

In the green pixel 10g, light transmitted through the bonding portion 130 may be incident on the green conversion layer 117g and converted into light of a green wavelength band. The light of the green wavelength band may be diffracted by the plurality of nano members 115 disposed in the periodic distance Pg, and may sequentially pass through the overcoat layer 114, the green color filter 113g, and the transparent substrate 111.

In the blue pixel 10b, light emitted from the light source 122 may pass through the bonding portion 130 and the transparent layer 118, and then may be diffracted by the plurality of nano members 115 disposed in the periodic distance Pb. The diffracted light may sequentially pass through the overcoat layer 114, the blue color filter 113b, and the transparent substrate 111.

In the display device 100 according to an embodiment, the plurality of nano members 115 may be disposed in the red pixel 10r, the green pixel 10g, and the blue pixel 10b in different periodic distances (periodic distances Pr, Pg, and Pb). According to an embodiment, the nano member 115 of periodic distances Pr, Pg, and Pb matched to the light of each of the red wavelength band, the green wavelength band, and the blue wavelength band may be disposed. Accordingly, light of each of the red wavelength band, the green wavelength band, and the blue wavelength band may be efficiently taken out from the display device 100 to the outside. Hereinafter, the operation effects are described using a comparative example.

FIG. 6A illustrates a main part configuration of a display device according to a comparative embodiment.

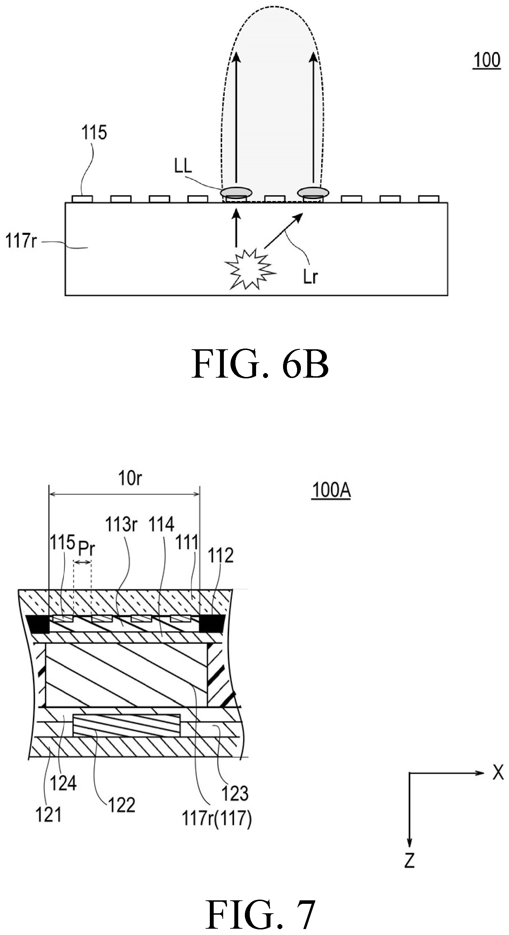

FIG. 6B illustrates a main part configuration of a display device according to an embodiment of the disclosure.

Referring to FIGS. 6A and 6B, a display device 1000 according to the comparative example may have no nano member (e.g., the nano member 115 of FIG. 1). In the display device 1000, since the light Lr from the red conversion layer 117r travels isotopically, the light Lr may be lost due to Fresnel reflection when taken out of the transparent substrate. For example, the light Lr incident on the transparent substrate at an angle of 41.8 degrees or more is totally reflected and may not be taken out of the display device 1000. It may also be applied corresponding to light from the green conversion layer and the transparent layer.

According to an embodiment, since the display device 100 is provided with the plurality of nano members 115, light Lr from the red conversion layer 117r may have a light localization phenomenon due to non-resonance near the nano member 115. Corresponding to the light from the green conversion layer 117g and the light from the transparent layer 118, light localization may occur near the nano member 115. Accordingly, the traveling direction of light may change. As shown in Equation 1 above, the wave vector of the diffracted light may be expressed using a lattice vector. The lattice vector may depend on the arrangement periodic distance of the nano members 115.

The plurality of nano members 115 disposed in the red pixel 10r in a periodic distance Pr may enhance directivity of light of the red wavelength band. The plurality of nano members 115 disposed in the green pixel 10g in a periodic distance Pg may enhance directivity of light of the green wavelength band. The plurality of nano members 115 disposed in the blue pixel 10b in a periodic distance Pb may enhance directivity of light of the blue wavelength band. Accordingly, directivity of light of each wavelength band taken out from each of the red pixel 10r, the green pixel 10g, and the blue pixel 10b may be enhanced, and thus loss of light due to Fresnel reflection may be suppressed. Further, the display device 100 may more efficiently take out light transmitted through each of the red conversion layer 117r, the green conversion layer 117g, and the transparent layer 118 to the outside. For example, as compared with the display device 1000, it is possible to take out light having an intensity of about 2.8 times in the red pixel 10r and the green pixel 10g and light having an intensity of about 2.0 times in the blue pixel 10b.

According to an embodiment, since the red conversion layer 117r and the green conversion layer 117g each include the plurality of nanoparticles 1172, the display device 100 may more efficiently convert light emitted from the light source 122 into light of the red wavelength band and light of the green wavelength band. For example, as compared to the red conversion layer and the green conversion layer that do not contain nanoparticles, it is possible to take out light having an intensity of about 1.4 times. Further, as the red conversion layer 117r and the green conversion layer 117g each include a plurality of nanoparticles 1172, wavelength conversion may be efficiently performed even when the concentration of the wavelength conversion materials 1171r and 1171g is reduced. Accordingly, the cost of the wavelength conversion materials 1171r and 1171g may be reduced.

Hereinafter, another embodiment and a modified embodiment of the display device 100 described above in the first embodiment are described. Further, a detailed description of the same components as those of the display device 100 described above in the first embodiment is omitted to avoid duplicate description.

[Second embodiment]

FIG. 7 illustrates an embodiment of a configuration of a red pixel of a display device according to an embodiment of the disclosure.

Referring to FIG. 7, in the red pixel 10r of the display device 100A, a plurality of nano members 115 may be provided between the transparent substrate 111 and the red color filter 113r. Further, the display device 100A may have a configuration corresponding to the display device 100 of the first embodiment.

A plurality of nano members 115 disposed in a periodic distance Pr may be provided between the transparent substrate 111 and the red color filter 113r. A plurality of nano members 115 disposed in a periodic distance Pg may be provided between the transparent substrate 111 and the green color filter 113g (not shown). A plurality of nano members 115 (not shown) disposed in a periodic distance Pb may be provided between the transparent substrate 111 and the blue color filter 113b.

The display device 100A may be formed, e.g., as described below. According to an embodiment, e.g., an amorphous silicon (a-Si) film may be formed on the transparent substrate 111 using a chemical vapor deposition (CVD) method at 200°C or less. Further, a low-temperature polysilicon (p-Si) film may be formed by heating and melting amorphous silicon using an excimer laser. After applying a resist film on the low-temperature polysilicon layer, the low-temperature polysilicon layer may be patterned by performing electron beam lithography and lift-off. Accordingly, a plurality of nano members 115 may be formed on the transparent substrate 111.

According to an embodiment, the color filter 113 and the overcoat layer 114 may be sequentially formed on the transparent substrate 111 to cover the plurality of nano members 115. Further, a red conversion layer 117r, a green conversion layer 117g, and a transparent layer 118 may be formed on the overcoat layer 114. Accordingly, the first structure 110 may be formed. According to an embodiment, the display device 100A may be manufactured by bonding the first structure 110 and the second structure 120 (see FIG. 1).

In the red pixel 10r of the display device 100A, light of a red wavelength band passing through the red conversion layer 117r may pass through the overcoat layer 114 and the red color filter 113r, and then may be diffracted by the plurality of nano members 115 arranged in the periodic distance Pr. The diffracted light may pass through the transparent substrate 111. The green pixel 10g and the blue pixel 10b may also be applied correspondingly.

In the display device 100A according to the second embodiment, the plurality of nano members 115 may be arranged in the red pixel 10r, the green pixel 10g, and the blue pixel 10b in different periodic distances (periodic distances Pr, Pg, and Pb). Accordingly, as described above in the first embodiment, light of each of the red wavelength band, the green wavelength band, and the blue wavelength band may be efficiently taken out from the display device 100A to the outside.

Further, in the display device 100A, since the plurality of nano members 115 are formed on the transparent substrate 111, the temperature used to form the plurality of nano members 115 may be allowed up to the heat-resistant temperature of the transparent substrate 111. Accordingly, the degree of freedom of the method for forming the plurality of nano members 115 may be enhanced. Further, since the transparent substrate 111 has high flatness, the plurality of nano members 115 may be formed in more accurate periodic distances (periodic distances Pr, Pg, and Pb).

[Modified example 1]

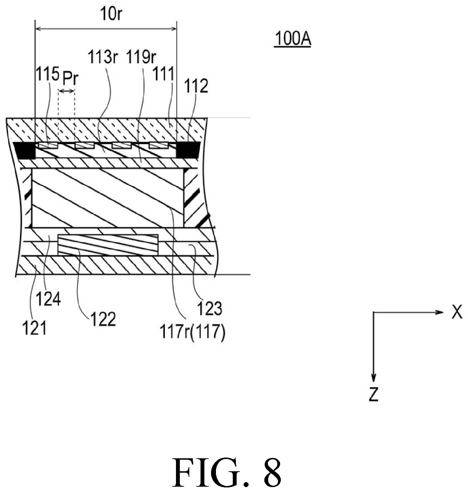

FIG. 8 illustrates a configuration of a red pixel of a display device according to modified example 1 according to an embodiment of the disclosure.

Referring to FIG. 8, the red pixel 10r of the display device 100A may have a dichroic filter 119r between the red conversion layer 117r and the red color filter 113r. Further, the display device 100A of modified example 1 may have a configuration corresponding to the display device 100A of the second embodiment.

The dichroic filter 119r may transmit light of a red wavelength band and simultaneously reflect light of a blue wavelength band. Accordingly, the light (light of the blue wavelength band) that is not wavelength-converted in the red conversion layer 117r may be reflected by the dichroic filter 119r and may be incident back on the red conversion layer 117r.

The green pixel 10g (not shown) of the display device 100A may have a dichroic filter between the green conversion layer 117g and the green color filter 113g. The dichroic filter may transmit light of a green wavelength band and simultaneously reflect light of a blue wavelength band. Accordingly, the light (light of the blue wavelength band) that is not wavelength-converted in the green conversion layer 117g may be reflected by the dichroic filter and may be incident back on the green conversion layer 117g.

The display device 100A may have an overcoat layer (e.g., the overcoat layer 114 of FIG. 7) between the dichroic filter 119r and the red conversion layer 117r.

In the display device 100A according to modified example 1, the plurality of nano members 115 may be disposed in the red pixel 10r, the green pixel 10g, and the blue pixel 10b in different periodic distances (periodic distances Pr, Pg, and Pb). Accordingly, as described above in the first embodiment, light of each of the red wavelength band, the green wavelength band, and the blue wavelength band may be efficiently taken out from the display device 100A to the outside.

Further, since the display device 100A has a dichroic filter (e.g., the dichroic filter 119r of FIG. 8), the display device 100A may more efficiently convert light of a blue wavelength band into light of a red wavelength band and light of a green wavelength band.

[Modified example 2]

The display device 100A (not shown) according to modified example 2 may have an overcoat layer 114 having a low refractive index. The refractive index of the overcoat layer 114 may be, e.g., 1.0 to 1.3. Further, the display device 100A of modified example 1 may have a configuration corresponding to the display device 100A of the second embodiment.

In the display device 100A, light (light of a blue wavelength band) that is not wavelength-converted in the red conversion layer 117r and the green conversion layer 117g may be reflected between the red conversion layer 117r and the green conversion layer 117g, and the overcoat layer 114. The reflected light may be incident back on the red conversion layer 117r and the green conversion layer 117g.

In the display device 100A according to modified example 2, the plurality of nano members 115 may be disposed in the red pixel 10r, the green pixel 10g, and the blue pixel 10b in different periodic distances (periodic distances Pr, Pg, and Pb). Accordingly, as described above in the first embodiment, light of each of the red wavelength band, the green wavelength band, and the blue wavelength band may be efficiently taken out from the display device 100A to the outside.

According to an embodiment, since the display device 100A has an overcoat layer 114 having a low refractive index, the display device 100A may more efficiently convert light of a blue wavelength band into light of a red wavelength band and light of a green wavelength band.

The above-described configuration of the display device 100 is described as the main configuration to describe the features of the above-described embodiments and modifications, and is not limited to the above-described configuration, and may be modified within the scope of the patent claim. Further, configurations provided by a general display device are not excluded.

For example, in the above-described embodiments, an example in which the red conversion layer 117r and the green conversion layer 117g include the nanoparticles 1172 has been described, but the disclosure is not limited thereto, and the red conversion layer 117r and the green conversion layer 117g may not include the nanoparticles. Further, one of the red conversion layer 117r and the green conversion layer 117g may not include nanoparticles.

Further, in the above-described embodiments, a case in which the light source 122 emits light in an ultraviolet to blue wavelength band has been described as an example, but the disclosure is not limited thereto, and the light source 122 may emit light in another wavelength band. Alternatively, a light source 122 emitting light of different wavelength bands from the red pixel 10r, the green pixel 10g, and the blue pixel 10b may be provided.

In the above-described embodiments, an example has been described in which the light source 122 includes a micro LED, but the disclosure is not limited thereto, and the light source 122 may include other light emitting elements. For example, the light source 122 includes an LED, an organic light emitting diode (OLED), or the like. The display device 100 may include a liquid crystal display device.

Further, in the above-described embodiments, the plurality of nano members 115 provided in the red pixel 10r, the green pixel 10g, and the blue pixel 10b may have the same shape or different shapes.

In the above-described embodiments, the blue pixel 10b has the transparent layer 118, but is not limited thereto. The blue pixel 10b may have a wavelength conversion layer.

Further, in the above-described embodiments, the case in which the light of the red wavelength band, the light of the green wavelength band, and the light of the blue wavelength band are taken out from the display device 100 is described as an example, but the wavelength band of the light taken out from the display device 100 is not limited thereto.

Further, in modified example 1 and modified example 2 described above, the display device 100A according to the second embodiment is described, but the display device 100 according to the first embodiment may have the same configuration. According to an embodiment, the display device 100 may have a dichroic filter 119r or the like, and may have an overcoat layer 114 having a low refractive index.

While the disclosure has been shown and described with reference to various embodiments thereof, it will be understood by those skilled in the art that various changes in form and details may be made therein without departing from the spirit and scope of the disclosure as defined by the appended claims and their equivalents.

**Claims**

1. A display device, comprising, at least:

   a light source provided in each of a first pixel and a second pixel and configured to emit light of a first wavelength;
   a first wavelength conversion layer formed in the first pixel and configured to convert the light of the first wavelength into light of a second wavelength;
   a second wavelength conversion layer formed in the second pixel and configured to convert the light of the first wavelength into light of a third wavelength different from the second wavelength;
   a first color filter provided in the first pixel and configured to selectively transmit the light of the second wavelength;
   a second color filter provided in the second pixel and configured to selectively transmit the light of the third wavelength; anda plurality of nano members on which the light of the second wavelength and the light of the third wavelength are incident,
   wherein the plurality of nano members include a high refractive index dielectric, and
   wherein the plurality of nano members are arranged in the first pixel in a first periodic distance, and
   wherein the plurality of nano members are arranged in the second pixel in a second periodic distance different from the first periodic distance.

2. The display device of claim 1, further comprising:

   an overcoat layer formed between the first color filter and the first wavelength conversion layer and between the second color filter and the second wavelength conversion layer,
   wherein the plurality of nano members are provided between the overcoat layer and each of the first wavelength conversion layer and the second wavelength conversion layer.

3. The display device of claim 1,

   wherein the light source is further provided in a third pixel, and
   wherein the plurality of nano members are further disposed in the third pixel in a third periodic distance different from the first periodic distance and the second periodic distance.

4. The display device of claim 3,

   wherein the light of the second wavelength is light of a red wavelength band, and
   wherein the light of the third wavelength is light of a green wavelength band.

5. The display device of claim 4,

   wherein the first periodic distance is longer than the second periodic distance, and
   wherein the second periodic distance is longer than the third periodic distance.

6. The display device of claim 4,

   wherein the first periodic distance is 500 nm or more and 700 nm or less,
   wherein the second periodic distance is 450 nm or more and 500 nm or less, and
   wherein the third periodic distance is 350 nm or more and 430 nm or less.

7. The display device of claim 1,

wherein the plurality of nano members arranged in the first periodic distance resonate with the light of the second wavelength, and
wherein the plurality of nano members disposed in the second periodic distance resonate with the light of the third wavelength.

8. The display device of claim 1, wherein the first wavelength conversion layer and the second wavelength conversion layer each include a plurality of nanoparticles.

9. The display device of claim 1, wherein the light of the first wavelength is light of a blue wavelength band.

10. The display device of claim 1, wherein the first wavelength conversion layer and the second wavelength conversion layer each include at least one of a quantum dot and a phosphor.

11. The display device of claim 1, further comprising:

an overcoat layer formed between the first color filter and the first wavelength conversion layer and between the second color filter and the second wavelength conversion layer; and
a transparent substrate facing the overcoat layer with the first color filter and the second color filter interposed therebetween,
wherein the plurality of nano members are provided between the transparent substrate, the first color filter, and the second color filter.

12. The display device of claim 1, further comprising:

a first dichroic filter provided between the first wavelength conversion layer and the first color filter and configured to transmit the light of the second wavelength and reflect the light of the first wavelength; and
a second dichroic filter provided between the second wavelength conversion layer and the second color filter and configured to transmit the light of the third wavelength and reflect the light of the first wavelength.

13. The display device of claim 1, wherein the plurality of nano members provided in a red pixel, a green pixel, and a blue pixel have a same shape or different shapes.

14. The display device of claim 13,

wherein the blue pixel has a transparent layer, and
wherein the blue pixel has a wavelength conversion layer.

15. The display device of claim 1, wherein the display device has a dichroic filter and an overcoat layer having a low refractive index.

FIG. 1

FIG. 2A

FIG. 2B

115

117r

FIG. 3A

115

117r

FIG. 3B

115

117r

FIG. 3C

115

117r

# FIG. 3D

117r

1171r

1172
1173

X

Z

# FIG. 4A

117r

1171r

1172
1173

X

Z

# FIG. 4B

1151 1152

114
113
111

X

Z

# FIG. 5A

200

114
113
111

1151  1152

Luv

X

Z

# FIG. 5B

1000

117r

Lr

# FIG. 6A

100

115

LL

Lr

117r

# FIG. 6B

100A

10r

115 Pr  113r  114  111  112

124
121  122  117r(117)  123

X

Z

# FIG. 7

FIG. 8

## INTERNATIONAL SEARCH REPORT

| International application No. |
| --- |
| **PCT/KR2024/020091** |

| A. | CLASSIFICATION OF SUBJECT MATTER |
| --- | --- |

**H10H 29/851**(2025.01)i; **H10H 29/14**(2025.01)i; **H10H 29/24**(2025.01)i; **H10H 29/85**(2025.01)i; **G02B 5/20**(2006.01)i

According to International Patent Classification (IPC) or to both national classification and IPC

| B. | FIELDS SEARCHED |
| --- | --- |

Minimum documentation searched (classification system followed by classification symbols)

H10H 29/851(2025.01); B32B 7/02(2006.01); G02B 26/00(2006.01); G02F 1/1333(2006.01); G02F 1/1335(2006.01); H01L 27/32(2006.01); H01L 51/52(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 화소(pixel), 광원(light source), 파장 변환층(wavelength conversion layer), 컬러 필터(color filter), 나노 부재(nano member), 고굴절률 유전체(high refractive index dielectric)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | KR 10-2455695 B1 (SAMSUNG DISPLAY CO., LTD.) 18 October 2022 (2022-10-18)<br>See paragraphs [0048] and [0061]-[0125]; and figures 4 and 8. | 1-15 |
| A | KR 10-1966672 B1 (SHINWHA INTERTEK CORP.) 09 April 2019 (2019-04-09)<br>See paragraph [0080]; and figure 5. | 1-15 |
| A | US 2023-0126988 A1 (LG DISPLAY CO., LTD.) 27 April 2023 (2023-04-27)<br>See paragraphs [0096]-[0108]; and figures 6A-6B. | 1-15 |
| A | KR 10-2023-0134608 A (CORNING INCORPORATED) 21 September 2023 (2023-09-21)<br>See paragraphs [0135]-[0136]; and figure 26. | 1-15 |
| A | KR 10-2282060 B1 (SAMSUNG DISPLAY CO., LTD.) 27 July 2021 (2021-07-27)<br>See claims 1-19; and figure 1. | 1-15 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **27 March 2025** | **28 March 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

| INTERNATIONAL SEARCH REPORT<br>Information on patent family members | | | | International application No.<br>**PCT/KR2024/020091** | | |
|---|---|---|---|---|---|---|

| Patent document<br>cited in search report | | | Publication date<br>(day/month/year) | Patent family member(s) | | | Publication date<br>(day/month/year) |
|---|---|---|---|---|---|---|---|
| KR | 10-2455695 | B1 | 18 October 2022 | CN | 109283750 | A | 29 January 2019 |
| | | | | CN | 109283750 | B | 07 June 2024 |
| | | | | KR | 10-2019-0010821 | A | 31 January 2019 |
| | | | | US | 11061268 | B2 | 13 July 2021 |
| | | | | US | 2019-0025634 | A1 | 24 January 2019 |
| KR | 10-1966672 | B1 | 09 April 2019 | KR | 10-2018-0107639 | A | 02 October 2018 |
| US | 2023-0126988 | A1 | 27 April 2023 | CN | 116033792 | A | 28 April 2023 |
| | | | | DE | 102022127714 | A1 | 27 April 2023 |
| | | | | KR | 10-2023-0058882 | A | 03 May 2023 |
| KR | 10-2023-0134608 | A | 21 September 2023 | CN | 115720617 | A | 28 February 2023 |
| | | | | CN | 116917797 | A | 20 October 2023 |
| | | | | EP | 4288830 | A1 | 13 December 2023 |
| | | | | JP | 2023-524045 | A | 08 June 2023 |
| | | | | JP | 2024-506849 | A | 15 February 2024 |
| | | | | KR | 10-2023-0003107 | A | 05 January 2023 |
| | | | | TW | 202146999 | A | 16 December 2021 |
| | | | | TW | 202238233 | A | 01 October 2022 |
| | | | | US | 11988919 | B2 | 21 May 2024 |
| | | | | US | 2023-0168541 | A1 | 01 June 2023 |
| | | | | US | 2024-0094580 | A1 | 21 March 2024 |
| | | | | WO | 2021-221908 | A1 | 04 November 2021 |
| | | | | WO | 2022-169643 | A1 | 11 August 2022 |
| KR | 10-2282060 | B1 | 27 July 2021 | CN | 108931863 | A | 04 December 2018 |
| | | | | CN | 108931863 | B | 23 August 2022 |
| | | | | KR | 10-2018-0128544 | A | 04 December 2018 |
| | | | | US | 10782553 | B2 | 22 September 2020 |
| | | | | US | 2018-0341147 | A1 | 29 November 2018 |

Form PCT/ISA/210 (patent family annex) (July 2022)